# EUROPÄISCHE PATENTSCHRIFT

(11) **EP 0 506 605 B1**
(45) Veröffentlichungstag und Bekanntmachung des Hinweises auf die Patenterteilung: **16.08.1995**
(21) Anmeldenummer: 92810030.4
(22) Anmeldetag: 17.01.1992
(51) Int. Cl.: G01R 33/09

(54) **Einrichtung zum Auffinden magnetisierbaren Materials in Bauwerken**
Device for detecting magnetisable material in buildings
Dispositif pour détecter du matériel magnétisable dans des bâtiments

(30) Priorität: 02.02.1991 DE 4103216
(43) Veröffentlichungstag der Anmeldung: 30.09.1992
(73) Patentinhaber: HILTI Aktiengesellschaft, 9494 Schaan (LI)
(72) Erfinder: Kousek, Heinz, Dr., A- 6800 Feldkirch (AT); Nipp, Hansjörg, FL-9493 Mauren (LI); Noser, Otto, FL-9490 Vaduz (LI); Ganahl, Otmar, A-6700 Blons Nr. 97 (AT); Leemann, Hans, FL-9491 Ruggell (LI)
(74) Vertreter: Wildi, Roland

(56) Entgegenhaltungen:
- AT-B- 367 915
- DE-A- 3 707 419
- DE-A- 3 801 627
- Beton- und Stahlbetonbau 84 (1989), Heft 11, Seiten 275 - 279
- Dugge, Karl-Wilhelm et al,: Grundlagen der Elektronik, Vogel-Buchverlag, Würzburg (1985), Seiten 372 - 375

## Beschreibung

Die Erfindung betrifft eine Einrichtung zum Auffinden magnetisierbaren Materials in Bauwerken gemäß dem Oberbegriff des Patentanspruchs 1.

Eine derartige Einrichtung ist bereits aus der Veröffentlichung von Andreas Schaab et al.: "Die zerstörungsfreie Prüfung der Betondeckung der Bewehrung" in: Beton- und Stahlbetonbau 84 (1989), Heft 11, Seiten 275 bis 279 und 324 bis 327 bekannt. Die bekannte Einrichtung enthält einen Abtastkopf, der einen Permanentmagneten zur Einleitung eines Magnetfelds in das Bauwerk sowie zwei im Polbereich am Permanentmagneten befestigte Magnetfeldsensoren zur Messung des durch das magnetisierbare Material gestörten Magnetfelds aufweist. Der Permanentmagnet ist als Stabmagnet ausgebildet und trägt an beiden einander gegenüberliegenden Polbereichen jeweils einen der Magnetfeldsensoren. Eine Auswerteeinheit dient zum Lokalisieren des magnetisierbaren Materials mit Hilfe von durch die Magnetfeldsensoren gelieferten Meßsignalen.

Der Permanentmagnet wird mit seiner einen Stirnseite auf das Bauwerk aufgesetzt, das beispielsweise ein Betonteil ist, und ändert bei Annähetung an einen Bewehrungsstab innerhalb des Betonteils seinen magnetischen Fluß. Genauer gesagt nimmt bei Annäherung des Abtastkopfs an einen unter der Betonoberfläche befindlichen Bewehrungsstab die magnetische Durchflutung an dem zwischen Stabmagnet und Bauteil liegenden Magnetfeldsensor zu. Mit einem Meßverstärker wird diese Durchflutungsänderung ausgewertet und als Betondeckung angezeigt.

Aus Dugge, Karl Wilhelm et al.: Grundlagen der Elektronik, Vogel-Buchverlag, Würzburg (1985), Seiten 372 - 375 ist es bereits bekannt, Differenzialfeldplatten zur Positionierung einer Eisenfahne zu verwenden. Bei den Differenzialfeldplatten handelt es sich um zwei auf einen gemeinsamen Trägere montierte, in Reihe geschaltete Feldplatten gleichen Grundwiderstandswertes. Derartige Differenzialfeldplatten können als Spannungsteiler oder in Brückenschaltung vorgesehen werden. Mit diesen Differenzialfeldplatten läßt sich eine sehr hohe Positioniergenauigkeit erreichen.

Nicht zuletzt ist es aus der DE 37 07 419 A1 bekannt, mehrere magnetfeldabhängige Widerstände direkt auf der Polfläche eines Magneten vorzusehen und in Brückenschaltung zusammenzuschalten.

Der Erfindung liegt die Aufgabe zugrunde, die Einrichtung der eingangs genannten Art so weiterzubilden, daß eine präzisiere Lokalisierung des magnetisierbaren Materials im Bauwerk über einen größeren Bereich in möglichst kurzer Zeit möglich ist.

Die Lösung der gestellten Aufgabe ist im kennzeichnenden Teil des Patentanspruchs 1 angegeben. Vorteilhafte Ausgestaltungen der Erfindung sind den Unteransprüchen zu entnehmen.

Eine Einrichtung nach der Erfindung zeichnet sich dadurch aus, daß
- die Magnetfeldsensoren Feldplatten sind,
- auf nur einer Polfläche des Magneten mehrere Paare von Jeweils in Differenzschaltung miteinander verbundenen Feldplatten liegen,
- die Paare entlang wenigstens einer Geraden angeordnet sind, derart, daß die zu Jeweils einem Paar gehörenden Feldplatten auf unterschiedlichen Seiten der Geraden liegen, und
- die Auswerteeinheit so ausgebildet ist, daß sie bei einer Verschiebung des Magneten entlang einer Oberfläche des Bauwerks quer zur Geraden von einen jeweiligen Paar an unterschiedlichen Verschiebepositionen gelieferte Differenzmeßwerte speichert, den Verlauf der Differenzmeßwerte differenziert und das Maximum des differenzierten Verlaufs bestimmt.

Der Magnet kann z. B ein Permanentmagnet oder ein Elektromagnet sein, der durch Wechselstrom oder alternierende Stromstöße anregbar ist. Im Falle eines Permanentmagneten wird eine relativ hohe Energiedichte erzielt, so daß auch ein relativ starkes Meßsignal erhalten wird. Energie für die Felderzeugung wird nicht benötigt, was sich insbesondere vorteilhaft bei Batteriegeräten auswirkt. Eine leichte Magnetisierung des magnetisierbaren Materials im Bauwerk kann dabei durchaus in Kauf genommen werden. Insbesondere läßt sich durch wiederholtes Messen ein derartiger Einfluß eliminieren. Im Falle eines Elektromagneten wird die Vormagnetisierung des magnetisierbaren Materials bei jeder Messung wieder gelöscht. Bei noch akzeptablem Stromverbrauch kommt jedoch nur ein relativ schwaches, primäres Feld zustande, so daß das Meßfeld relativ klein ist. Die Meßsignale müssen daher zusätzlich gefiltert werden, was einen größeren schaltungstechnischen Aufwand erfordert.

Die Feldplatten sind bereits allgemein bekannt. Es handelt sich bei ihnen um magnetisch steuerbare Widerstände aus z. B. InSb/NiSb, deren Beeinflußbarkeit auf dem Gaußeffekt beruht. Die den Halbleiter durchlaufenden Ladungsträger werden durch die Einwirkung eines Magnetfelds aufgrund der Lorenzkraft seitlich abgelenkt, und zwar je nach Größe des Magnetfelds unterschiedlich stark, was zu einer magnetfeldabhängigen Widerstandsänderung führt.

Um mit der erfindungsgemäßen Einrichtung ein magnetisierbares Material in einem Bauwerk aufzufinden, beispielsweise eine Stahlbewehrung in einem Betonteil, wird der Abtastkopf so auf das Bauwerk aufgesetzt, daß die Feldplatten zwischen der Stirnfläche des Permanentmagneten und dem Bauwerk zu liegen kommen. Sodann wird an mehreren Positionen auf der Bauwerksoberfläche die senkrecht zur Bauwerksoberfläche liegende Magnetfeldkomponente gemessen, die nachfolgend als vertikale Magnetfeldkomponente bezeichnet wenden soll. Genauer gesagt mißt jede der beiden Feldplatten eines Paares eine vertikale Magnetfeldkomponente. Da beide Feldplatten in Differenzschaltung miteinander verbunden sind, wird jedoch nur ein einziger Meßwert erhalten, der der relativen Widerstandsänderung beider Feldplatten bzw. der Differenz der durch beide Feldplatten gemessenen vertikalen Magnetfeldkomponenten entspricht, Dieser Meßwert wird nachfolgend als Differenzmeßwert bezeichnet. Er kann z. B. mit Hilfe eines Differenzverstärkers gewonnen werden. Jede Position des Abtastkopfs auf der Bauwerksoberfläche, an der eine Messung durchgeführt wird, wird darüber hinaus registriert, um eine Zuordnung zwischen Differenzmeßwert und Meßposition zu ermöglichen. Zudem wird auch die Richtung derjenigen Geraden, auf der beide Feldplatten liegen, erfaßt, um den durch den Differenzmeßwert ermittelten Feldgradienten (Änderung der vertikalen Magnetfeldkomponente) richtungsmäßig festlegen zu Können, Durch Zusammenstellung mehrere Differenzmeßwerte entlang von gewünschten Bahnen und unter Berücksichtigung der genannten Richtungen, die jeweils in Bahnrichtung liegen, lassen sich ortsabhängige Differenzmeßsignale erzeugen, die anschließend differenziert werden. Die Nullstelle eines Differenzmeßsignals bzw. das Maximum eines differenzierten Differenzmeßsignals ergibt dann die genaue Position des magnetisierbaren Materials im Bauwerk.

Mehrere Paare von Feldplatten sind entlang einer Geraden angeordnet, wobei die Feldplatten eines Paares untereinander in Reihe geschaltet und mit Mittelabgriffen verbunden sind. Die jeweiligen Differenzmeßwerte der vertikalen Magnetfeldkomponenten lassen sich dann durch jeweils zwei benachbarte dieser Feldplatten bilden. Hierzu werden die an den End- und Mittelabgriffen liegenden Signale der Feldplatten-Reihenschaltung jeweils entsprechenden Differenzverstärkern zugeführt. Auf diese Weise läßt sich die Zeit zur Aufnahme der einzelnen Differenzmeßwerte sowie zur Erstellung der Differenzmeßsignale erheblich verkürzen.

Wie bereits erwähnt, sind die Feldplattenpaare entlang einer Geraden angeordnet, Dabei liegt vorteilhaft die Verbindungslinie zwischen jeweils zwei Feldplatten eines Feldplattenpaares senkrecht zur genannten Geraden. Werden die Feldplattenpaare, die auf der Geraden liegen, gemeinsam verschoben, und zwar senkrecht zur Geraden, so lassen sich für jede Verschiebeposition der Geraden die Differenzmeßwerte der einzelnen und auf der Geraden liegenden Feldplattenpaare in kurzer Zeit nacheinander oder-gleichzeitig abfragen. Die Differenzmeßwerte jeweils eines Feldplattenpaares für unterschiedliche Verschiebepositionen der Geraden werden dann zu einem Differenzmeßsignal zusammengestellt, um später durch Differenzierung des jeweiligen Differenzmeßsignals eine exakte Positionsbestimmung des magnetisierbaren Materials im Bauwerk zu ermöglichen. Die Verschieberichtung der Geraden liegt also in Richtung der bereits oben genannten Bahnen.

Eine weitere vorteilhafte Ausgestaltung der Erfindung wird dadurch erhalten, daß die Feldplattenpaare entlang paralleler Geraden in Form eines zweidimensionalen, regelmäßigen Musters angeordnet sind, Grundsätzlich bräuchte in einem solchen Fall eine Verschiebung der Feldplattenpaare nicht zu erfolgen, wenn nur genügend viele Feldplattenpaare vorhanden sind. Alle Verbindungslinien jeweils zweier Feldplatten eines Feldplattenpaares könnten parallel liegen, wobei es aber auch möglich ist, für die Verbindungslinien unterschiedliche Richtungen vorzusehen. Beispielsweise könnten zwei Gruppen von Feldplattenpaaren vorhanden sein, die um 90° versetzte Richtungen der Verbindungslinien zwischen den jeweiligen Feldplatten eines Paares aufweisen. Durch die unterschiedlich ausgerichteten Feldplattenpaare läßt sich das Bauwerk in einer entsprechend großen Anzahl von Richtungen abtasten, so daß der Verlauf des magnetisierbaren Materials innerhalb des Bauwerks genauer ermittelt werden kann.

Diejenigen Feldplattenpaare, deren Verbindungslinien auf derselben Geraden liegen, könnten auch durch eine entsprechende Feldplattenzeile von elektrisch in Reihe geschalteten Feldplatten gebildet werden. Die Anzahl der Feldplatten entlang dieser Zeile kann dabei gerade oder ungerade sein. Durch paarweise Zusammenschaltung jeweils benachbarter Feldplatten entlang der Feldplattenzeile lassen sich dann ebenfalls die gewünschten Differenzmeßwerte gewinnen.

Nach einer weiteren vorteilhaften Ausgestaltung der Erfindung ist unter jeder Feldplatte ein Polschuh angeordnet. Hierdurch kann das zu messende Magnetfeld auf den Bereich der Feldplatte konzentriert werden, wodurch sich die Empfindlichkeit der Meßeinrichtung erhöht.

Entsprechend der Erfindung können die Polschuhe eines Feldplattenpaares untereinander auch verbunden sein. Die genaue Positionierung einzelner Polschuhe für die jeweiligen Feldplatten ist schwierig, da Polschuhe und Feldplatten relativ klein sind. Die beiden Polschuhe eines Feldplattenpaares werden daher aus einem Stück gefertigt, wobei die Verbindung zwischen den Polschuhen durch eine dünne Platte ausgeführt ist, die am Magneten anliegt. Durch die dünne Platte wird nur der Magnet geringfügig verlängert, was nicht störend ist.

Nach einer weiteren, sehr vorteilhaften Ausgestaltung der Erfindung ist der Magnet entlang einer zwischen den beiden Feldplatten eines Feldplattenpaares verlaufenden Linien unterteilt, wobei ein gemeinsames Feldplattensubstrat auf den zum Feldplattenpaar gehörenden Polschuhen liegt. Der Magnet weist also einen Luftspalt im Bereich zwischen den beiden Feldplatten des Feldplattenpaares auf. Hierdurch läßt sich die Flußdifferenz zwischen beiden Feldplatten erhöhen, was zu einer noch größeren Empfindlichkeit der Einrichtung führt.

Eine sehr vorteilhafte weitere Ausgestaltung der Erfindung besteht darin, daß die jeweiligen Feldplatten eines Feldplattenpaares stirnseitig mit jeweils einer Fahne aus hochpermeablem Material verbunden sind, die voneinander abstehen und sich entlang einer in Verbindungsrichtung beider Feldplatten verlaufenden Geraden erstrecken.

Durch diese Fahnen läßt sich einerseits die Empfindlichkeit der Einrichtung weiter erhöhen, da die Fahnen auch als Feldkonzentrator dienen. Andererseits wird durch die Fahnen eine bessere Positionsauflösung erreicht, da infolge der Fahnen die Maxima der gemessenen vertikalen Magnetfeldkomponenten der Feldplatten eines jeden Paares weiter auseinandergezogen werden. Das Differenzmeßsignal weist somit im Bereich des magnetisierbaren Materials einen steileren Verlauf auf, so daß das durch Differenzieren des Differenzmeßsignals erhaltene Differentiationssignal schmaler und höher ist. Infolgedessen läßt sich der Ort des magnetisierbaren Materials einfacher und genauer ermitteln.

Zur Messung der Positionen der Feldplattenpaare kann der Abtastkopf mit einem Wegaufnehmer verbunden sein, so daß sich die Position des Abtastkopfs und damit die der Feldplattenpaare, ausgehend von einer Referenzposition, exakt bestimmen lassen. Wird beispielsweise der Abtastkopf auf das Bauwerk aufgesetzt, so kann ein Positionswert (Referenzposition) mit Hilfe einer geeigneten Schalteinrichtung auf Null gesetzt werden. Bei Bewegung des Abtastkopfs liefert dann der Wegaufnehmer entsprechende Positionssignale, so daß sich bei der Aufnahme der Differenzmeßwerte diesen Differenzmeßwerten feste Positionen relativ zur Referenzposition zuordnen lassen. Die Referenzposition muß natürlich auf dem Bauwerk vermerkt werden, beispielsweise durch eine entsprechenden Markierung.

Vorzugsweise sind die Feldplattenpaare in einem auf Rädern laufenden Wagen angeordnet, wobei die Radachsen parallel zu den Geraden liegen. Mit einer derartigen Anordnung läßt sich das Bauwerk in besonders einfacher Weise auf magnetisierbares Material absuchen, da der Wagen nur über die Oberfläche des Bauwerks gerollt zu werden braucht. Die Abtastrichtung ist durch die Laufrichtung des Wagens vorgegeben. Der Wagen kann auch mehrmals in unterschiedlichen Richtungen über eine abzusuchende Oberfläche des Bauwerks hinweggefahren werden, um ein genaueres Bild des magnetisierbaren Materials im Bauwerk zu erhalten. Die Struktur des magnetisierbaren Materials läßt sich z. B. auf einem Monitor optisch darstellen.

Um den Wagen wiederholt entlang definierter Bahnen auf dem Bauwerk laufen zu lassen, kann die Laufrichtung des Wagens durch eine mit Laufrinnen versehene Platte definiert werden, die auf die Oberfläche des Bauwerks aufgelegt wird. Die Platte kann beispielsweise eine gepreßte Platte aus magnetisch nichtleitendem Material sein. Die Laufrinnen nehmen dabei die Räder des Wagens auf, um diesen zu führen. Statt der Platte kann auch eine Prägefolie verwendet werden. Auf der Platte bzw. Folie ist insbesondere die Startposition für den Wagen sowie für jede Meßspur markiert. Die Laufrinnen können dabei so eingebracht sein, daß sich der Wagen entlang unterschiedlicher Richtungen und in jeweils einer Richtung entlang parallel zueinanderliegender Bahnen bewegen läßt.

Wie bereits eingangs erwähnt, kann der Magnet ein Permanentmagnet oder ein Elektromagnet sein. Im Falle eines Permanentmagneten lassen sich die Feldplatten entweder direkt oder indirekt im Bereich einer Polfläche mit dem Permanentmagneten verbinden. Bei einem Elektromagneten ist ein entsprechender Magnetkern vorhanden, der zur Bildung der genannten Polfläche dient. Der Magnetkern wird von einer Spule umgeben und weist im wesentlichen die gleiche rechteckige oder ovale Größe bzw. Polfläche auf, die auch der Permanentmagnet besitzt. Wenn von einer Unterteilung des Magneten die Rede ist, so ist beim Elektromagneten die Unterteilung des Magnetkerns gemeint.

Die Erfindung wird nachfolgend unter Bezugnahme auf die Zeichnung näher beschrieben. Es zeigen:
- Fig. 1: eine perspektivische Gesamtansicht des geometrischen Aufbaus der erfindungsgemäßen Einrichtung mit einem Abtastwagen und einer Auswerteeinheit,
- Fig. 2: einen Schnitt durch den Abtastwagen parallel zu einer Seitenwand und senkrecht zu seinen Radachsen (Linie II-II in Fig. 1),
- Fig. 3: eine Teildraufsicht auf einen Teil der Bodenfläche des Abtastwagens, an der sich entlang einer Geraden angeordnete Feldplattenpaare befinden (Pfeil III in Fig. 2),
- Fig. 4: Signalverläufe zum Aufsuchen der exakten Position von magnetisierbarem Material im Bauwerk,
- Fig. 5: ein grobes Blockschaltdiagramm der erfindungsgemäßen Einrichtung,
- Fig. 6: Signalverläufe zur Tiefen- und Dickenbestimmung von magnetisierbarem Material im Bauwerk,
- Fig. 7: eine perspektivische Teilansicht der Unterseite des Abtastwagens, die zwei auf Polschuhen liegende Feldplatten zeigt,
- Fig. 8: eine perspektivische Teilansicht der Unterseite des Abtastwagens, die zwei auf Polschuhen liegende Feldplatten zeigt, die mit hochpermeablen Fahnen verbunden sind,
- Fig. 9: eine perspektivische Teilansicht der Unterseite des Abtastwagens, die einen im Bereich zwischen zwei Feldplatten eines Feldplattenpaares geteilten Permanentmagneten zeigt,
- Fig. 10: eine Draufsicht auf die Unterseite eines Abtastkopfs bzw. Abtastwagens mit regelmäßig angeordneten und in gleicher Weise ausgerichteten Feldplattenpaaren, und
- Fig. 11: eine Draufsicht auf die Unterseite eines Abtastkopfs bzw. Abtastwagens mit regelmäßig angeordneten Feldplattenpaaren, die jedoch unterschiedlich ausgerichtet sind.

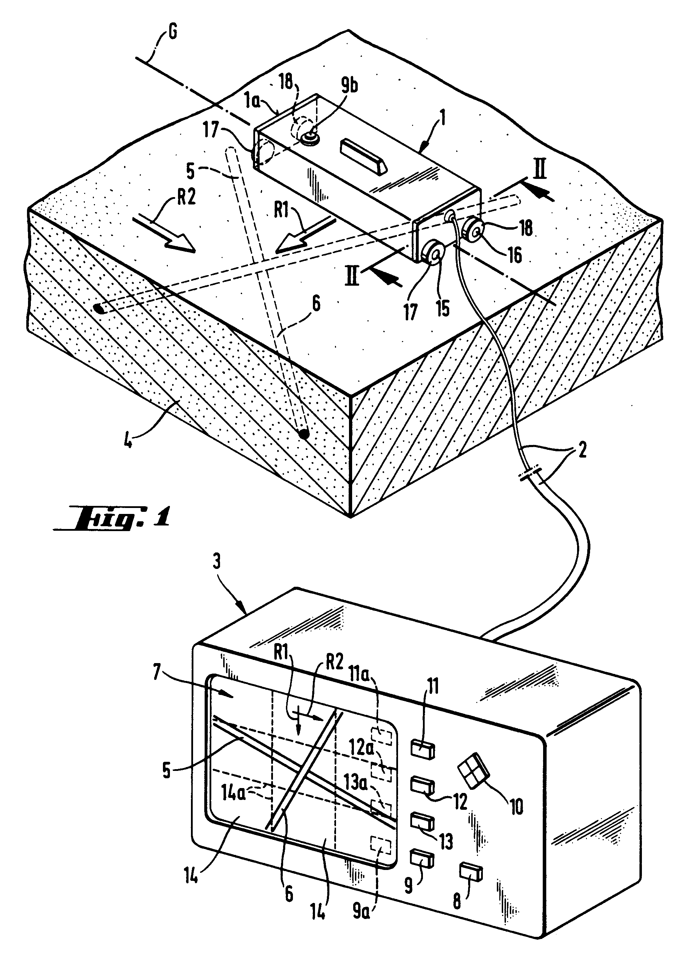

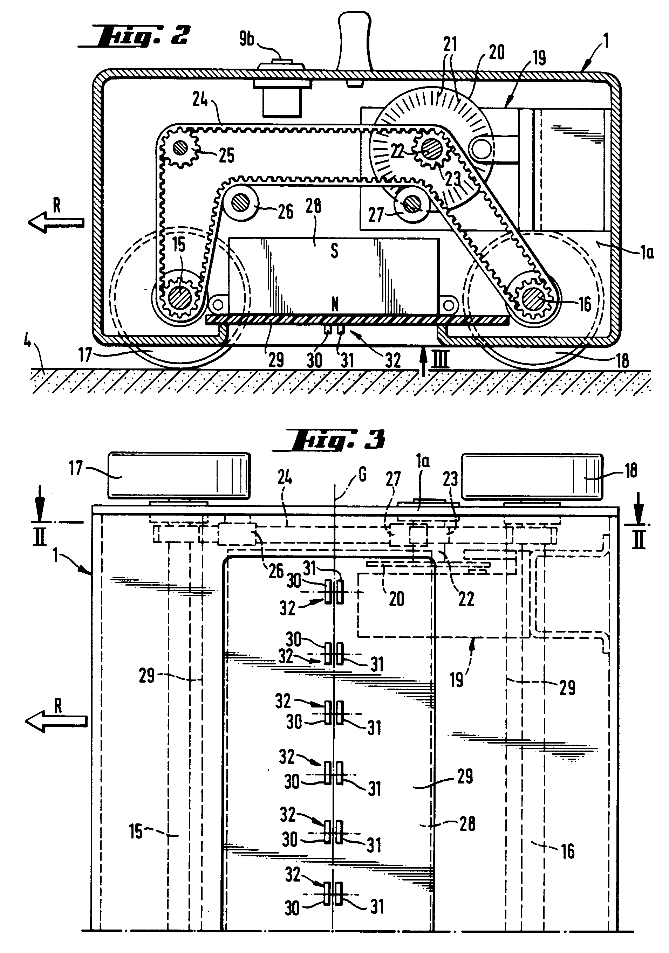

In der Fig. 1 ist ein Ausführungsbeispiel einer erfindungsgemäßen Einrichtung zum Auffinden magnetisierbaren Materials in Bauwerken dargestellt. Diese Einrichtung weist einen Abtastwagen 1 auf, der über ein Kabel 2 mit einer Auswerteeinheit 3 verbunden ist. Der Abtastwagen 1 befindet sich auf einer Betonplatte 4, welche ein Armierungseisen enthält, vorliegend zwei Eisenstangen 5 und 6. Die Auswerteeinheit 3 weist einen Monitor 7 auf, auf welchem sich die durch den Abtastwagen 1 detektierten Eisenstangen 5 und 6 abbilden lassen. Sie enthält ferner eine Reihe von Tasten 11, 12, 13 und 9 zur Steuerung des Meßvorgangs sowie zur Betätigung von Bildverarbeitungs- und -auswertefunktionen. Die Bedienerführung erfolgt durch Einblendungen 11a, 12a, 13a und 9a am Bildschirmrand neben diesen Tasten, die die jeweilige Funktion erklären. Damit läßt sich eine Anpassung an nationale Sprachen sowie eine Ergänzung weiterer Bedienungsmöglichkeiten per Software durchführen, wobei die Frontplatte des Geräts übersichtlich bleibt. Eine Taste 8 ermöglicht ein Vorund Zurückblättern in einem übergeordneten Menü. Vier Tasten 10 dienen zur Bewegung eines Cursors auf dem Bildschirm.

Die Bildverarbeitungsfunktionen erlauben die Veränderung der Helligkeit und des Kontrasts entweder im Gesamtbild als auch in einem wählbaren Teilbereich (Zoom-Fenster). Der bearbeitete Teilbereich kann in das ursprüngliche Bild eingeblendet werden. Weiterhin stehen Filterfunktionen zur Glättung lokaler Bildstörungen zur Verfügung. Zu den Auswertefunktionen zählt die Anzeige der Koordinaten der Cursorposition sowie die Einblendung eines Koordinatennetzes, das eine maßstabsähnliche Darstellung einer Schablone zeigt, die auf das Bauwerk aufgelegt wird, um den Meßwagen zu führen. Damit wird die Rückübertragung der Position des magnetisierbaren Materials in bezug auf das Bauwerk erleichtert.

Die Auswerteeinheit 3 kann weiterhin mit nicht dargestellten anderen Einheiten verbunden werden, beispielsweise mit einem Drucker oder mit einem Computer.

Soll in einem gewünschten Bereich der Betonplatte 4 ein Bild der in ihr vorhandenen Armierung erzeugt werden, so wird dieser Bereich mit Hilfe des Abtastwagens 1 abgetastet. Zur Führung des Abtastwagens 1 kann eine mit Laufrinnen versehene Platte oder Folie verwendet werden, die auf das Bauwerk gelegt oder aufgeklebt wird. Im folgenden sei angenommen, daß ein quadratischer Bereich abgetastet werden soll, dessen Kantenlänge der dreifachen Länge des Abtastwagens 1 entspricht. Dieser Bereich soll darüber hinaus in zwei rechtwinklig zueinander liegenden Richtungen abgetastet werden, um ein möglichst genaues Bild der Armierung erhalten zu können. Der Abtastbereich erscheint auf dem Monitor 7 der Auswerteeinheit 3 und ist in neun Teilbereiche unterteilt, wie durch die gestrichelten Linien zu erkennen ist. Der Abtastbereich trägt das Bezugszeichen 14, während die gestrichelten Linien mit dem Bezugszeichen 14a versehen sind.

Nach Aufsetzen des Abtastwagens 1 auf die Betonplatte 4 wird zunächst eine Referenzpositions-Einstelltaste 9b betätigt, um die Referenzposition für die Positionsbestimmung der vom Abtastwagen 1 gelieferten Meßwerte auf den Wert Mull zu setzen. Der Abtastwagen 1 wird dann in einer ersten Richtung R1 über die Betonplatte 4 hinweggerollt, so daß praktisch die auf dem Monitor 7 gezeigten linken drei Teilbereiche des Abtastbereichs 14, die in einer Spalte untereinander liegen, überstrichen werden. Dieser Vorgang wird für die mittlere und für die rechte Spalte des Abtastbereichs 14 wiederholt, wozu der Abtastwagen 1 entsprechend neu und versetzt zur ersten Bahn auf der Betonplatte 4 positioniert wird. Sodann wird der Bereich auf der Betonplatte 4 in einer dazu senkrechten Richtung R2 mit Hilfe des Abtastwagens 1 abgetastet, so daß nacheinander die in den jeweiligen Zeilen des Abtastbereichs 14 liegenden Teilbereiche überstrichen werden. Die beim Überstreichen der Teilbereiche vom Abtastwagen 1 gemessenen Daten werden ausgewertet, wie nachfolgend noch beschrieben wird, um die Lage der Eisenstangen 5 und 6 innerhalb der Betonplatte 4 zu detektieren und ein entsprechendes Bild auf dem Monitor 7 zu erzeugen. Selbstverständlich muß beim Abtasten des gewünschten Oberflächenbereichs der Betonplatte 4 die oben genannte Reihenfolge eingehalten werden, da die Auswerteeinheit 3 entsprechend programmiert ist. Bei Änderung der Programmierung kann der Abtastbereich 14 aber auch in anderer Weise unterteilt sein und abgetastet werden.

Die oben beschriebene kreuzweise Abtastung ist sinnvoll, da nur Eisenstangen, die quer zur Abtastrichtung verlaufen, die gewünschten Meßsignale liefern. Eisenstangen, die schräg zur Abtastrichtung liegen (bis etwa 45°) liefern in Abtastrichtung ein auseinandergezogenes Signal, wobei etwa der Cosinussatz gilt. Der Signalanstieg ist dann geringer, so daß beim Differenzieren ein niedrigerer Signalpegel erhalten wird. Der fehlende Betrag wird aber vom Abtastvorgang senkrecht zu der zuerst genannten Richtung erbracht und hinzuaddiert, so daß wieder eine für die Auswertung hinreichende Signalhöhe erhalten wird. Eisenstangen, die längs der Abtastrichtung verlaufen, liefern kein zeitlich veränderliches Signal und werden somit nicht detektiert. Selbstverständlich werden nur Signalpegel für dieselben Abtastpositionen addiert, so daß im Rechner schließlich ein dreidimensionaler Signalverlauf erhalten wird. Zu diesem Zweck können auch mehr als zwei Abtastrichtungen gewählt werden.

Um den Abtastwagen 1 auf der Oberfläche der Betonplatte 4 leicht bewegen zu können, ist er mit zwei parallel zueinander liegenden Achsen 15 und 16 versehen, an deren Enden sich jeweils Räder 17 und 18 befinden. Die Radachsen 15 und 16 sind miteinander drehgekoppelt, um einen möglichst einwandfreien Geradeauslauf des Abtastwagens 1 zu gewährleisten. Durch die Laufrichtung des Abtastwagens 1 wird eine Meßrichtung R vorgegeben, die senkrecht zu den Achsen 15 und 16 liegt. Die Meßrichtung R ist beispielsweise die Richtung R1 und R2 in Fig. 1.

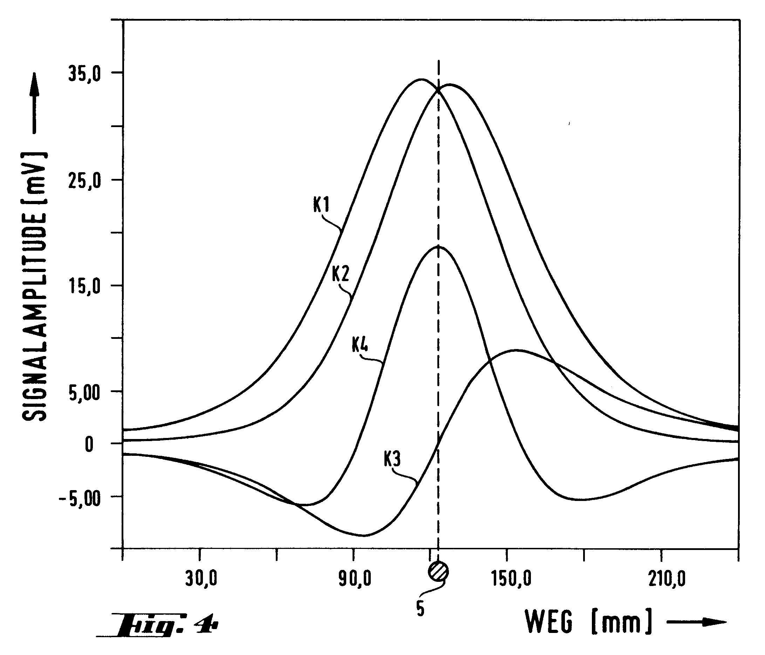

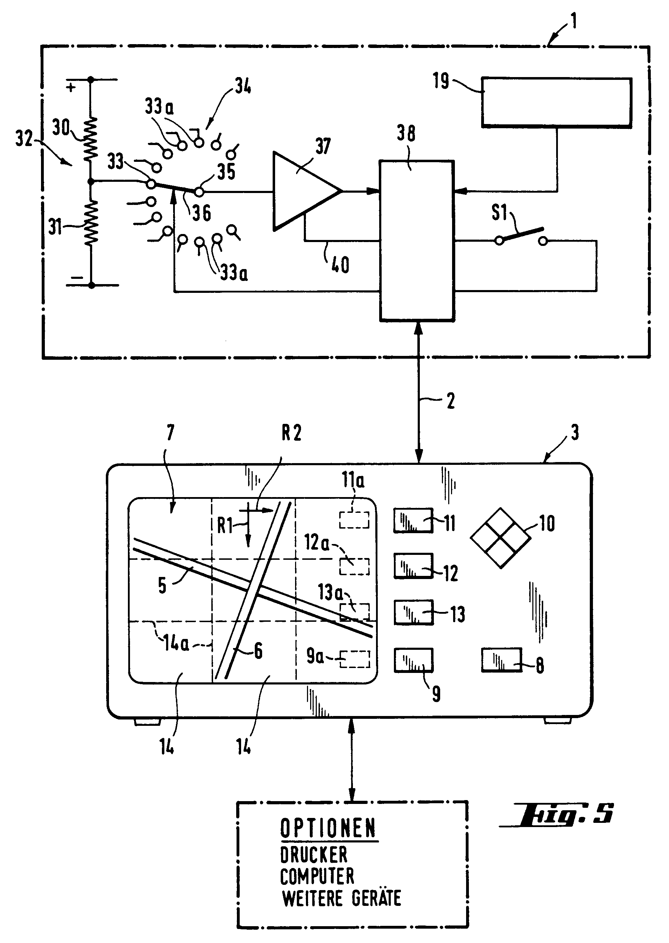

Die Fig. 2 zeigt einen Schnitt durch den Abtastwagen 1 auf eine Innenseitenwand, die senkrecht zur Richtung der Achsen 15 und 16 liegt. Die Meßrichtung R verläuft somit in Fig. 2 in horizontaler Richtung.

Wie zu erkennen ist, befindet sich innerhalb des Abtastwagens 1 ein Schlitzblenden-Wegaufnehmer 19, der eine drehbare Schlitzblende 20 aufweist, deren Schlitze 21 mit einer elektrooptischen Abtasteinrichtung abgetastet werden, die nicht im einzelnen gezeigt ist. Die Schlitzblende 20 ist auf einer Achse 22 drehbar gelagert, die ihrerseits an einer Seitenwand 1a des Abtastwagens 1 befestigt ist. Über einen mit der Schlitzscheibe 20 befestigten Ansatz 23 läuft ein Treibriemen 24, der sowohl über Umlenkrollen 25, 26 und 27 als auch über die beiden Achsen 15 und 16 geführt ist. Rollt der Abtastwagen 1 auf der Oberfläche der Betonplatte 4 entlang, so wird die Schlitzscheibe 20 mit Hilfe des Treibriemens 24 gedreht, was dazu führt, daß die elektrooptische Einrichtung je zurückgelegter Einheitsstrecke des Abtastwagens 1, die sich durch den Abstand der Schlitze 21 in der Schlitzscheibe 20 ergibt, ein Pulssignal liefert. Die entsprechenden Pulssignale werden gezählt, so daß sich aus dem Zählwert die genaue Position des Abtastwagens 1, ausgehend von der Referenzposition, bestimmen läßt. Die Referenzposition wird durch Betätigung der Referenzpositions-Einstelltaste festgelegt, wodurch der Zählwert auf Null gesetzt wird. Die elektrooptische Detektoreinrichtung kann beispielsweise aus einer lichtemittierenden Diode und einem photoempfindlichen Element bestehen.

In Übereinstimmung mit Fig. 2 ist zwischen den Radachsen 15 und 16 sowie am Boden des Abtastwagens 1 ein Magnet 28 angeordnet, der in diesem Beispiel ein Permanentmagnet ist, und der z. B. oben seinen Südpol und unten seinen Nordpol aufweist. Der Permanentmagnet 28 ist am Abtastwagen 1 fest positioniert und erstreckt sich praktisch über die gesamte Länge des Abtastwagens 1. Die Länge des Permanentmagneten 28 ist dabei wesentlich größer als dessen Breite bzw. Höhe. Der Permanentmagnet könnte auch durch den Kern eines entsprechenden Elektromagneten ersetzt werden. Unterhalb des Permanentmagneten 28 und an diesem befestigt befindet sich eine gedruckte Schaltungsplatte 29, an deren Unterseite aus jeweils zwei Feldplatten 30, 31 bestehende Feldplattenpaare 32 angeordnet sind. Die Feldplattenpaare 32 sind über nicht dargestellte elektrische Leitungsverbindungen auf der gedruckten Schaltungsplatte 29 mit einem Mikroprozessor verbunden, der ebenfalls auf der gedruckten Schaltungsplatte 29 liegt.

Wie anhand der Fig. 2 zu erkennen ist, liegen die Feldplatten 30 und 31 eines Feldplattenpaares 32 in Abtastrichtung R hintereinander. Darüber hinaus sind mehrere Feldplattenpaare 32, z. B. vierzehn Feldplattenpaare, an der Unterseite der gedruckten Schaltungsplatte 29 sowie in Längsrichtung des Abtastwagens 1 nebeneinanderliegend angeordnet, also in Richtung der Achsen 15 und 16 bzw. parallel zu ihnen.

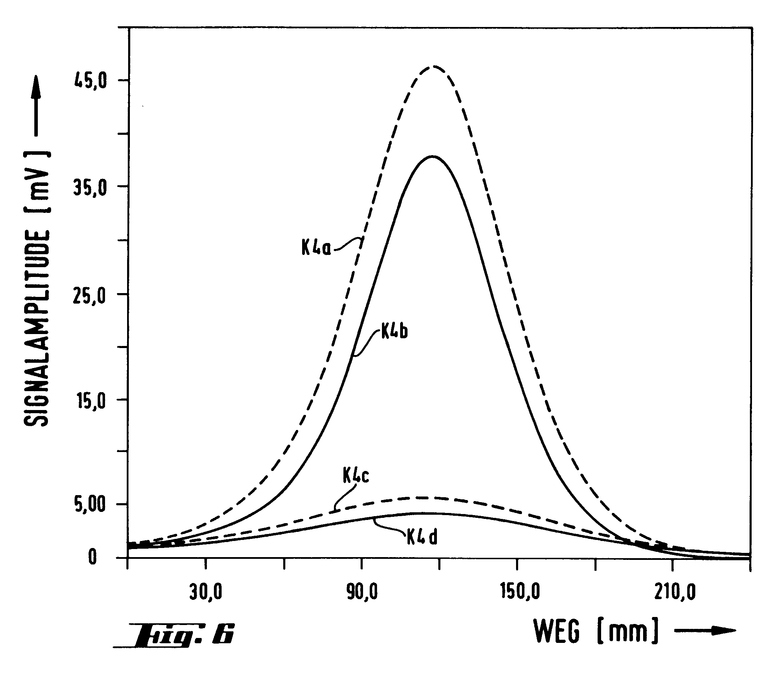

Die Fig. 3 zeigt die Anordnung der Feldplattenpaare 32 auf der Unterseite der gedruckten Schaltungskarte 29 im einzelnen. Es handelt sich hier um eine Draufsicht auf die Unterseite der gedruckten Schaltungsplatte 29. Mit R ist wiederum die Meßrichtung angegeben, die senkrecht zu den Achsen 15 und 16 in Fig. 2 verläuft. Die Meßrichtung R stellt also gleichzeitig die Bewegungsrichtung des Abtastwagens 1 dar. Die Feldplattenpaare 32 weisen senkrecht zur Meßrichtung R einen gleichen Abstand untereinander auf und liegen auf einer gemeinsamen Geraden. In Meßrichtung R bzw. senkrecht zur Geraden G sind die Feldplatten 30 und 31 eines jeweiligen Feldplattenpaares 32 voneinander beabstandet, um die Vertikalkomponente des Magnetfelds des Permanentmagneten 28 zu messen.

Wie bereits erwähnt, ändert sich die vertikale Magnetfeldkomponente des Permanentmagneten 28 bei Annäherung des Meßwagens 1 an eine im Beton liegende Eisenstruktur. Die Feldplatten 30, 31 erfassen die vertikale Magnetfeldkomponente an zweinahe zueinander benachbarten Stellen in Übereinstimmung mit dem Abstand der Feldplatten. Da die beiden Feldplatten 30, 31 eines jeweiligen Feldplattenpaares 32 in Differenzschaltung geschaltet sind, wird durch sie unmittelbar der Differenzwert zwischen den beiden vertikalen Magnetfeldkomponenten erfaßt, so daß sie einen Differenzmeßwert ausgeben. Dieser Differenzmeßwert entspricht praktisch dem Gradienten der vertikalen Magnetfeldkomponente in Verbindungsrichtung der beiden Feldplatten des Feldplattenpaares bzw. in Meßrichtung R.

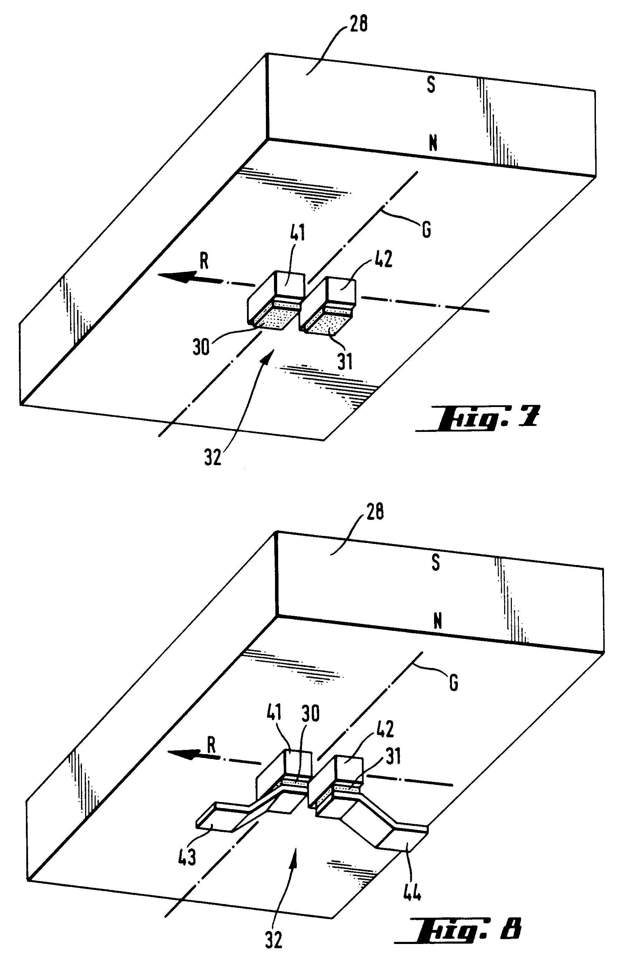

Die Fig. 4 zeigt die zugehörigen Signaleverläufe. Die Kurven K1 und K2 stellen die Meßwerte jeweils einer Feldplatte 30, 31 des Feldplattenpaares 32 dar, während die Kurve K3 die Differenzmeßwerte eines Feldplattenpaares 32 darstellt. In Fig. 4 sind die jeweiligen Signalamplituden über den Weg aufgetragen. Der Weg ist der Verschiebeweg des Abtastwagens 1 in Meßrichtung R. Die Kurve K4 gibt den differenzierten Signalverlauf des Differenzmeßsignals K3 an.

Genauer gesagt wird für jeweils eine Verschiebeposition des Abtastwagens 1 für alle Feldplattenpaare 32 der Differenzmeßwert ermittelt und gespeichert. In einer nächsten Verschiebeposition des Abtastwagens 1 in Meßrichtung R erfolgt wiederum die Aufnahme von Differenzmeßwerten durch die Feldplattenpaare 32, usw. Auf diese Weise wird für jeweils ein Differenzplattenpaar 32 eine Kurve K3 erhalten, wie sie in Fig. 4 gezeigt ist. Nach vollständiger Verschiebung des Abtastwagens 1 und somit vollständiger Aufnahme der Kurve K3 in Fig. 4 für jedes Differenzplattenpaar 32 werden die Rurven K3 differenziert, um jeweils differenzierte Signalverläufe K4 zu erhalten. Das Maximum des differenzierten Signalverlaufs K4 liegt am Ort des magnetisierbaren Materials, im vorliegenden Fall z. B. am Ort einer Eisenstange 5 in Fig. 4.

Diagramme nach Fig. 4 werden also für jedes Feldplattenpaare 32 gebildet und auch für jede Abtastrichtung R, falls der Abtastwagen 1 entlang verschiedener Abtastrichtungen R1 und R2 auf der Oberfläche der Betonplatte 4 in Fig. 1 bewegt wird. Anhand der so ermittelten, differenzierten Signalverläufe K4 läßt sich dann in herkömmlicher Weise durch Maximabestimmung, Filterung und dergleichen ein Bild der Armierung in der Betonplatte 4 erzeugen und auf dem Monitor 7 von Fig. 1 abbilden.

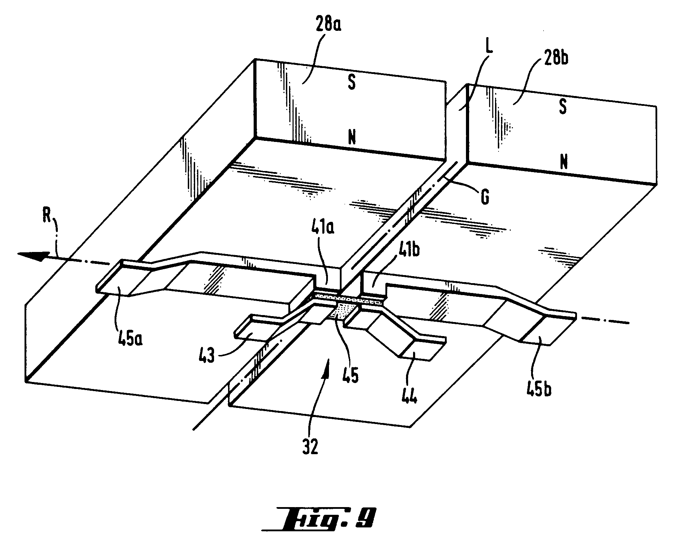

Die Fig. 5 zeigt den elektrischen Aufbau der erfindungsgemäßen Einrichtung in weiteren Details. Der Abtastwagen 1 enthält vierzehn Feldplattenpaare 32 mit jeweils zwei Feldplatten 30 und 31, die in Reihe geschaltet sind und zwischen einem positiven und einem negativen Spannungspol liegen. Der Mittelabgriff zwischen den Feldplatten 30 und 31 gelangt an einen Anschluß 33 eines Multiplexers 34. Die anderen Anschlüsse 33a des Multiplexers 34 sind ebenfalls mit jeweils einem Mittelabgriff eines anderen Feldplattenpaares 32 verbunden. Ein gemeinsamer Kontakt 35 des Multiplexers 34 wird mit Hilfe eines Umschalters 36 mit den einzelnen Anschlüssen 33 der Reihe nach verbunden, so daß die an den Mittelabgriffen der jeweiligen Feldplattenpaare 32 erhaltenen Differenzmeßwerte der Reihe nach über einen Verstärker 37 einem Mikroprozessor 38 zugeführt werden. Die Differenzmeßwerte werden dann für jede Position des Abtastwagens 1 im Mikroprozessor 38 gespeichert, wozu ein entsprechender Speicherbereich vorgesehen ist. Die jeweilige Position des Abtastwagens 1 wird durch den bereits erwähnten Wegaufnehmer 19 (Positionsaufnehmer) ermittelt. Dabei werden die durch den Positionsaufnehmer 19 ermittelte Position und die bei dieser Position gemessenen Differenzmeßwerte einander zugeordnet. Nach Verschiebung des Abtastwagens 1 erfolgt eine entsprechende Messung der Differenzmeßwerte bei einer neuen Position

Sämtliche auf diese Weise erhaltenen Differenzmeßwerte werden zu den in Fig. 4 gezeigten Differenzmeßsignalen 3 zusammengestellt und können schon im Mikroprozessor 38 des Abtastwagens 1 differenziert werden, um die differenzierte Meßsignalkurve K4 zu erhalten. Sie kann aber auch alternativ in der Auswerteeinheit 3 ermittelt und zur Bilddarstellung verarbeitet werden.

Es sei noch erwähnt, daß in Fig. 5 der Schaltkontakt 36 unter Steuerung des Mikroprozessors 38 über eine Leitung 39 umgeschaltet wird, während ein Abgleich des Verstärkers 37 durch den Mikroprozessor 38 über eine Leitung 40 erfolgt. Ein mit dem Mikroprozessor 38 verbundener Schalter S1 dient zur automatischen Umschaltung der Verstärkung bei Überschreitung des Meßbereichs.

Die Fig. 6 zeigt ein dem Diagramm nach Fig. 4 entsprechendes Diagramm, wobei jedoch nur differenzierte Signalverläufe K4a, K4b, K4c und K4d aufgetragen sind. Der Signalverlauf nach K4a gilt für einen Stabdurchmesser von 22 mm in einer Tiefe von 39 mm, der Signalverlauf nach K4b für einen Stabdurchmesser von 8 mm in einer Tiefe von 36 mm, der Signalverlauf nach K4c für einen Stabdurchmesser von 22 mm in einer Tiefe von 89 mm und der Signalverlauf nach K4d für einen Stabdurchmesser von 8 mm in einer Tiefe von 86 mm. Die Amplituden sind jeweils in mV ab Feldplatte aufgetragen.

Man erkennt, daß die Signalamplitude sehr stark von der Eisentiefe bzw. Überdeckung abhängt. Dagegen hängt die Signalamplitude schwach vom Stabdurchmesser ab. Sämtliche Stäbe bestehen im vorliegenden Fall aus Eisen. Kurven ähnlicher Tiefe liegen relativ nahe beeinander, auch wenn sie von stark unterschiedlich dicken Stäben herrühren. Kurven unterschiedlicher Stabtiefe liegen dagegen sehr weit auseinander. Die Breite der Kurven (Zunahme des Signals bei Annäherung des Abtastkopfs an die Stelle, unter der das Eisen liegt, und symmetrisch dazu die Abnahme danach) hängt praktisch nicht vom Durchmesser des Stabs ab, wohl aber von der Tiefenlage.

Die Auswertung der Signalverläufe erfolgt so, daß zunächst aus der Amplitude grob auf die Tiefe geschlossen wird, während anschließend aus dem Verhältnis Kurvenbreite zu Höhe der Stabdurchmesser ermittelt wird. Mit dieser Information wird dann noch die Tiefe korrigiert. Natürlich können auch Vergleichskurven von bekannten Signalverläufen herangezogen und mit den gemessenen Signalverläufen verglichen werden, um auf Stabdurchmesser und Tiefenlage zu schließen.

Die Fig. 7 zeigt eine Ansicht des Abtastwagens 1 von schräg unten im Bereich der Feldplattenpaare. Im einzelnen ist ein Feldplattenpaar 32 mit den Feldplatten 30 und 31 zu erkennen, wobei jede der Feldplatten 30 und 31 auf einem Polschuh 41, 42 liegt. Die Polschule 41 und 42 dienen dazu, das magnetische Feld des Permanentmagneten 28 auf den Bereich der Feldplatten 30 und 31 zu konzentrieren, so daß sich eine größere Empfindlichkeit der erfindungsgemäßen Einrichtung ergibt. Die gedruckte Schaltungskarte 29 aus Fig. 2 ist der Übersicht wegen nicht dargestellt und liegt ansonsten zwischen den Feldplatten 30 bzw. 31 und den jeweiligen Polschuhen 41 bzw. 42. Es sei darauf hingewiesen, daß jede Feldplatte 30 bzw. 31 aus einem Leiterelement mit dem magnetisch veränderbaren Widerstand und einem Substrat bzw. Träger besteht, auf dem dieser magnetisch veränderbare Widerstand ruht. In den Figuren ist dies nicht in getrennter Weise dargestellt, um die Zeichnungen nicht zu kompliziert erscheinen zu lassen.

Die Fig. 7 zeigt weiter, daß die Meßrichtung R in Verbindungsrichtung der beiden Feldplatten 30 und 31 liegt, während die Längsrichtung des Permanentmagneten 28 senkrecht dazu verläuft. Die Längsrichtung ist mit dem Doppelpfeil G markiert. In Längsrichtung G liegen weitere Feldplattenpaare 32 gemäß Fig. 7, die jedoch der Übersicht wegen nicht dargestellt sind.

Abweichend vom Ausführungsbeispiel nach Fig. 7 können die Polschuhe 41 und 42, die aus magnetisch leitendem Material bestehen, auch einstückig miteinander verbunden sein, beispielsweise durch einen schmalen Steg, der an der Seite des Permanentmagneten 28 liegt und mit diesem in Kontakt steht. Die Polschuhe 41 und 42 brauchen dann nicht gesondert montiert zu werden, sondern lassen sich als Paar auf den Permanentmagneten 28 aufsetzen, was erheblich einfacher ist, da die Polschuhe 41, 42 relativ klein sind.

Die Fig. 8 zeigt eine weitere Ausgestaltung der Erfindung im Bereich der Feldplattenpaare 32. Direkt auf jeder Feldplatte 30, 31 liegt eine Fahne 43, 44 aus hochpermeablem Material. Die Fahnen 43 und 44 erstrecken sich jeweils ausgehend von den jeweiligen Feldplatten 30, 31 voneinander weg und in bzw. entgegen der Meßrichtung R.

Durch die Fahnen 43, 44 läßt sich einerseits das Feld des Permanentmagneten 28 in noch stärkerer Weise auf die Feldplatten 30, 31 konzentrieren. Hierdurch wird eine weitere Empfindlichkeitserhöhung der Einrichtung erreicht.

Andererseits ist es aber auch möglich, durch die Fahnen 43 und 44 die Maxima der Kurven K1 und K2 in Fig. 4 weiter auseinanderzuziehen, so daß sich ein steilerer Verlauf der Differenzmeßsignalkurve K3 ergibt und damit ein schmalerer bzw. steilerer Verlauf der differenzierten Kurve K4, wodurch ein höheres Auflösungsvermögen bei der Positionsbestimmung des magnetisierbaren Materials im Bauwerk erhalten wird.

Eine noch weitere Ausgestaltung der Erfindung im Bereich der Feldplattenpaare 32 ist in Fig. 9 gezeigt. Hier ist der Permanentmagnet in zwei Permanentmagnethälften 28a und 28b unterteilt, zwischen denen ein Luftspalt L zu liegen kommt. An der Unterseite der Permanentmagnete 28a und 28b befindet sich jeweils ein Polschuh 41a, 41b, in deren Bereich jeweils eine Feldplatte liegt. Die Feldplatten sind auf einem gemeinsamen Substrat 45 angeordnet, das z. B. aus Keramik besteht. Das Substrat 45 liegt auf beiden Polschuhen 41a und 41b auf. Oberhalb der Feldplatten befinden sich wiederum die Fahnen 43, 44 aus hochpermeablem Material. Sie erstrecken sich wie in Fig. 8 in oder entgegengesetzt zur Meßrichtung R. Die Polschuhe 41a und 41b sind darüber hinaus mit Erweiterungen 45a, 45b einstückig verbunden, die nach außen aufgebogen sind, um vor allem eine leichte Korrekturmöglichkeit für die Feldsymmetrie zu haben. Die gedruckte Schaltungsplatte 29 ist auch hier der Übersicht wegen nicht dargestellt und liegt zwischen den Polschuhen 41a, 41b und dem Substrat 45.

Durch die Anordnung nach Fig. 9 läßt sich die Flußdifferenz zwischen den beiden Feldplatten erhöhen, was zur Verbesserung der Meßempfindlichkeit beiträgt. Die Polschuhe leiten den magnetischen Fluß von den Teilmagneten 28a und 28b durch die auf dem gemeinsamen Substrat 45 aus isolierender Keramik angeordneten Feldplatten und darunter über die Feldplatten, die weitere Polschuhe bilden, wieder auseinander in das Außenfeld

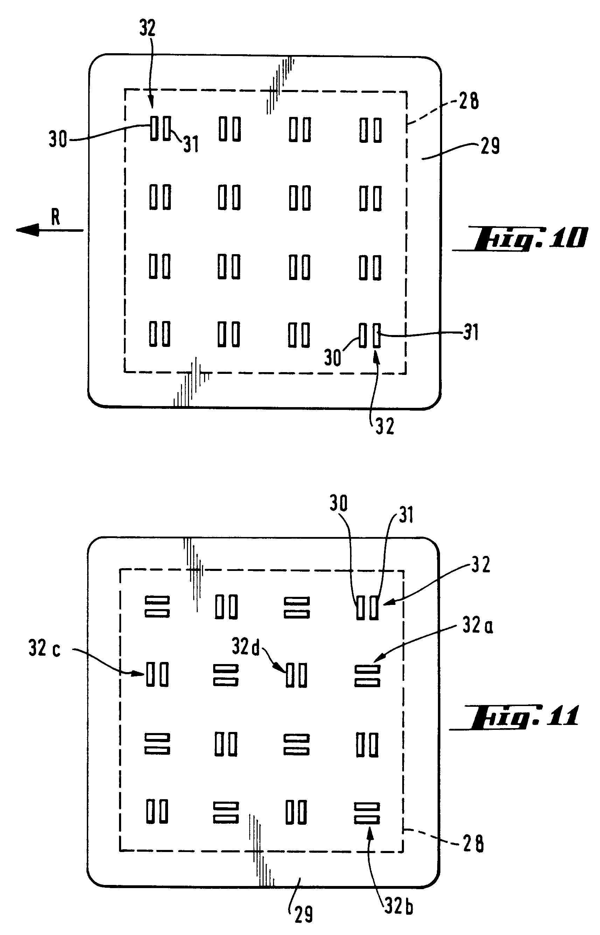

Die Fig. 10 zeigt eine zweidimensionale Anordnung von Feldplattenpaaren 32. Die Feldplattenpaare 32 liegen auf einer Seite der gedruckten Schaltungskarte 29, auf deren anderer Seite sich der Permanentmagnet 28 befindet, der in diesem Fall eine quadratische Polfläche aufweist. Beispielsweise sind 4 x 4 = 16 Feldplattenpaare dargestellt, die alle in gleicher Weise relativ zur Meßrichtung R ausgerichtet sind und darüber hinaus unter gleichmäßigem Abstand zueinander liegen und ein regelmäßiges Raster bilden. Diese Anordnung hat den Vorteil, daß der Abtastwagen 1 zur Ermittlung der Differenzmeßwerte nicht mehr so weit verschoben zu werden braucht. Es genügt im Prinzip eine Verschiebung um den Abstand zweier Feldplattenpaare in Meßrichtung R. Für unterschiedliche Meßrichtungen muß der Abtastwagen 1 jedoch nach wie vor geschwenkt werden. Sind sehr viele Feldplattenpaare sehr dicht nebeneinanderliegend im Bereich der Polfläche des Permanentmagneten 28 angeordnet, so könnte unter Umständen auf eine Verschiebung des Abtastwagens auch ganz verzichtet werden. Hierbei könnte dann allerdings nur in einer Richtung gemessen werden, so daß sich unter Umständen nicht das gesamte magnetisierbare Material im Bauwerk nachweisen ließe. Ein Eisendraht, der parallel zur Abtastrichtung R verläuft, könnte dann nicht erfaßt werden.

Die in Fig. 10 jeweils in Abtastrichtung R hintereinander angeordneten Feldplattenpaare könnten auch in Form einer Feldplattenzeile vorliegen, also in Form einer Reihenschaltung von entsprechend vielen Feldplatten, im vorliegenden Fall von acht Feldplatten, wobei jeweils End- und Mittelagriffe vorhanden sind. Die Meßsignale von jeweils zwei benachbarten Feldplatten werden dann paarweise ausgewählt. Sämtliche Feldplatten könnten dabei jeweils den gleichen bestand voneinander aufweisen.

Eine Weiterbildung der Anordnung nach Fig. 10 ist in Fig. 11 dargestellt. Dort sind wiederum 16 = 4 x 4 Feldplattenpaare 32 dargestellt, die ein regelmäßiges, zweidimensionales Gitter bilden. Die Meßrichtungen wechseln jedoch in Horizontalrichtung und in Vertikalrichtung von Feldplattenpaar zu Feldplattenpaar, so daß hier insgesamt zwei Meßrichtungen erhalten werden. Diese Meßrichtungen stehen senkrecht zueinander. Bei dieser Anordnung sind dann nur noch sehr geringe Verschiebungen in den beiden Meßrichtungen erforderlich, um die jeweiligen Differenzmeßwerte für die entsprechenden Verschiebepositionen aufnehmen zu können. Eine Verschiebung könnte auch in diesem Fall entfallen, wenn genügend viele und eng zueinander benachbarte Feldplattenpaare mit jeweils in Horizontal- und Vertikalrichtung abwechselnden Meßrichtungen vorhanden sind, um hinreichend genaue Meßsignalverläufe (Kurven gemäß K3 in Fig. 4) zu erhalten. Gegebenenfalls könnte auch zwischen zwei ermittelten Meßwerten in einer Meßrichtung bei nicht eng genug zusammenliegenden Feldplattenpaaren interpoliert werden, um auf rechnerischem Wege Zwischenwerte zur Vervollständigung der Kurve K3 in Fig. 4 zu erhalten. Verschiedene Meßwerte für die Meßsignalkurve K3 in Fig. 4 würde man gemäß Anordnung nach Fig. 11 z. B. durch die Feldplattenpaare 32a und 32b oder durch die Feldplattenpaare 32c und 32d erhalten. In der Praxis sind erheblich mehr Feldplattenpaare vorhanden, je nach gewünschtem Anwendungszweck und Größe der abzutastenden Bauwerkfläche.

## Patentansprüche

1. Einrichtung zum Auffinden magnetisierbaren Materials (5, 6) in Bauwerken, mit
- einem Abtastkopf, der einen Magneten (28) zur Einleitung eines Magnetfeldes in das Bauwerk sowie wenigstens zwei im Polbereich am Magneten (28) befestigte Magnetfeldsensoren (30, 37) zur Messung des durch das magnetisierbare Material (5, 6) gestörten Magnetfeldes aufweist, und
- einer Auswerteeinheit (3) zum Lokalisieren des magnetisierbaren Materials (5, 6) mit Hilfe von durch die Magnetfeldsensoren (30, 37) gelieferten Meßsignalen,
**dadurch gekennzeichnet**, daß
- die Magnetfeldsensoren (30, 31) Feldplatten sind,
- auf nur einer Polfläche des Magneten (28) mehrere Paare (32) von jeweils in Differenzschaltung miteinander verbundenen Feldplatten liegen,
- die Paare (32) entlang wenigstens einer Geraden (G) angeordnet sind, derart, daß die zu jeweils einem Paar (32) gehörenden Feldplatten auf unterschiedlichen Seiten der Geraden (G) liegen, und
- die Auswerteeinheit (3) so ausgebildet ist, daß sie bei einer Verschiebung des Magneten (28) entlang einer Oberfläche des Bauwerks quer zur Geraden (G) von einem jeweiligen Paar (32) an unterschiedlichen Verschiebepositionen gelieferte Differenzmeßwerte speichert, den Verlauf der Differenzmeßwerte differenziert und das Maximum des differenzierten Verlaufs bestimmt.

2. Einrichtung nach Anspruch 1, **dadurch gekennzeichnet**, daß die Feldplattenpaare (32) entlang paralleler Geraden in Form eines zweidimensionalen, regelmäßigen Musters angeordnet sind.

3. Einrichtung nach Anspruch 1 oder 2, **dadurch gekennzeichnet**, daß eine Verbindungslinie zwischen jeweils zwei Feldplatten (30, 31) eines Feldplattenpaares (32) senkrecht zu den genannten Geraden liegt.

4. Einrichtung nach einem der Ansprüche 1 bis 3, **dadurch gekennzeichnet**, daß unter jeder Feldplatte (30, 31) ein Polschuh (41, 42 bzw. 41a, 41b) angeordnet ist.

5. Einrichtung nach Anspruch 4, **dadurch gekennzeichnet**, daß die Polschuhe eines Feldplattenpaares untereinander verbunden sind.

6. Einrichtung nach Anspruch 4, **dadurch gekennzeichnet**, daß der Magnet entlang einer zwischen den beiden Feldplatten eines Feldplattenpaares verlaufenden Linie unterteilt ist und ein gemeinsames Feldplattensubstrat (45) auf den zum Feldplattenpaar gehörenden Polschuhen (41a, 41b) liegt.

7. Einrichtung nach einem der Ansprüche 1 bis 6, **dadurch gekennzeichnet**, daß die jeweiligen Feldplatten (30, 31) eines Feldplattenpaares (32) stirnseitig mit jeweils einer Fahne (43, 44) aus hochpermeablem Material verbunden sind, die voneinander abstehen und sich entlang einer in Verbindungsrichtung beider Feldplatten verlaufenden Geraden erstrecken.

8. Einrichtung nach einem der Ansprüche 1 bis 7, **dadurch gekennzeichnet**, daß sie einen Wegaufnehmer (19) zur Positionsbestimmung des Abtastkopfs (1) aufweist.

9. Einrichtung nach einem der Ansprüche 5 bis 8, **dadurch gekennzeichnet**, daß die Feldplattenpaare (32) in einem auf Rädern (17, 18) laufenden Wagen (1) angeordnet sind und die Radachsen (15, 16) parallel zu den Geraden liegen.

10. Einrichtung nach Anspruch 9, **dadurch gekennzeichnet**, daß zwei parallele und miteinander drehgekoppelte Radachsen (15, 16) vorhanden sind, an deren Enden sich jeweils ein Rad (17, 18) befindet.

11. Einrichtung nach Anspruch 9 oder 10, **dadurch gekennzeichnet**, daß der Wegaufnehmer (19) ein Schlitzblenden-Wegaufnehmer mit einer drehbaren Schlitzblende (20) ist, die durch Drehung wenigstens einer der Radachsen (15, 16) angetrieben wird.

12. Einrichtung nach einem der Ansprüche 1 bis 11, **dadurch gekennzeichnet**, daß der Magnet ein Permanentmagnet ist.

13. Einrichtung nach einem der Ansprüche 1 bis 12, **dadurch gekennzeichnet**, daß der Magnet ein Elektromagnet ist.

## Claims

1. A device for locating magnetisable material (5, 6) in a structure, having
- a scanning head which comprises a magnet (28) for introducing a magnetic field into the structure and at least two magnetic field sensors (30, 37) attached to the magnet (28) in its pole region for measuring the magnetic field disturbed by the magnetisable material (5, 6), and
- an evaluation unit (3) for localising the magnetisable material (5, 6) with the aid of measuring signals supplied by the magnetic field sensors (30, 37),
characterised in that
- the magnetic field sensors (30, 31) are magnetoresistors,
- a plurality of pairs (32) of magnetoresistors, each connected to each other in a differential circuit, are situated on one pole face only of the magnet (28),
- the pairs (32) are disposed along at least one straight line (G) in such a way that the magnetoresistors belonging to each pair (32) are situated on different sides of the straight line (G), and
- the evaluation unit (3) is designed so that on a displacement of the magnet (28) transversely to the straight line (G) along a surface of the structure it stores the differential readings supplied by a respective pair (32) at different positions of displacement, differentiates the progression of the differential readings and determines the maximum of the differential progression.

2. A device according to claim 1, characterised in that the magnetoresistor pairs (32) are disposed in the form of a regular, two-dimensional pattern along parallel straight lines.

3. A device according to claim 1 or 2, characterised ill that the connecting line between two magnetoresistors (30, 31) of each magnetoresistor pair (32) is perpendicular to the said straight line.

4. A device according to any one of claims 1 to 3, characterised in that a pole piece (41, 42; 41a, 41b) is disposed under each magnetoresistor (30, 31).

5. A device according to claim 4, characterised in that the pole pieces of a magnetoresistor pair are connected to each other.

6. A device according to claim 4, characterised in that the magnet is subdivided along a line running between the two magnetoresistors of a magnetoresistor pair, and a common magnetoresistor substrate (45) is situated on the pole pieces (41a, 41b) belonging to the magnetoresistor pair.

7. A device according to any one of claims 1 to 6, characterised in that the respective magnetoresistors (30, 31) of a magnetoresistor pair (32) are each connected at their end faces to a vane (43, 44) of high-permeability material, which vanes stand away from each other and extend along a straight line running in the direction of connection of both magnetoresistors.

8. A device according to any one of claims 1 to 7, characterised in that it comprises a distance sensor (19) for determining the position of the scanning head (1).

9. A device according to any one of claims 5 to 8, characterised in that the magnetoresistor pairs (32) are disposed in a carriage (1) running on wheels (17, 18), and the wheel axles (15, 16) are parallel to the straight lines.

10. A device according to claim 9, characterised in that two parallel wheel axles (15, 16) are present, which are coupled to each other and at the ends of which a wheel (17, 18) is situated in each case.

11. A device according to claim 9 or 10, characterised in that the distance sensor (19) is a slit diaphragm distance sensor having a rotatable slit diaphragm (20) which is driven by the rotation of at least one of the wheel axles (15, 16).

12. A device according to any one of claims 1 to 11, characterised in that the magnet is a permanent magnet.

13. A device according to any one of claims 1 to 12, characterised in that the magnet is an electromagnet.

## Revendications

1. Dispositif pour détecter un matériau magnétisable (5, 6) dans des bâtiments, comprenant une tête de sondage munie d'un amant (28) pour la création d'un champ magnétique dans le bâtiment ainsi qu'au moins deux détecteurs de champ magnétique (30, 31) fixés sur l'aimant (28) dans la région polaire, pour la mesure du champ magnétique perturbé par le matériel magnétisable (5, 6), et une unité d'exploitation (3) pour la localisation du matériau magnétisable (5, 6) à l'aide de signaux de mesure fournis par les détecteurs de champ magnétique (30, 31), caractérisé en ce que les détecteurs de champ magnétique (30, 31) sont des magnétorésistances, que plusieurs paires (32) de magnétorésistances couplées à chaque fois en circuit différenciateur sont montées sur une seule face polaire de l'aimant (28), que les paires (32) sont disposées le long d'au moins une droite (G), de telle façon que les magnétorésistances associées respectivement à une paire (32) se situent sur des côtés différents de la droite (G), et que l'unité d'exploitation (3) est réalisée de telle façon que, lors d'un déplacement de l'aimant (28) le long d'une surface du bâtiment, transversalement à la droite (G), elle mémorise des valeurs de mesure différentielles fournies par une paire (32) considérée à différentes positions de déplacement, qu'elle différencie l'allure des valeurs de mesure différentielles et détermine le maximum de l'allure différenciée.

2. Dispositif selon la revendication 1, caractérisé en ce que les paires de magnétorésistances (32) sont disposées le long de droites parallèles sous la forme d'un dessin régulier bidimensionnel.

3. Dispositif selon l'une des revendications 1 ou 2, caractérisé en ce qu'une ligne de liaison entre respectivement deux magnétorésistances (30, 31) d'une paire de magnétorésistances (32) est orientée perpendiculairement à ladite droite.

4. Dispositif selon l'une quelconque des revendications 1 à 3, caractérisé en ce qu'une pièce polaire (41, 42 et respectivement 41a, 41b) est disposée sous chaque magnétorésistance (30, 31).

5. Dispositif selon la revendication 4, caractérisé en ce que les pièces polaires d'une paire de magnétorésistances sont reliées entre elles.

6. Dispositif selon la revendication 4, caractérisé en ce que l'aimant est subdivisé le long d'une ligne qui s'étend entre les deux magnétorésistances d'une paire de magnétorésistances, et qu'un substrat de magnétorésistance commun (45) repose sur les pièces polaires (41a, 41b) associées à la paire de magnétorésistances.

7. Dispositif selon l'une quelconque des revendications 1 à 6, caractérisé en ce que les magnétorésistances (30, 31) respectives d'une paire de magnétorésistances (32) sont à chaque fois reliées du côté frontal à un talon (43, 44) constitué d'un matériau très perméable, lesdits tallons étant éloignés l'un de l'autre et s'étendant le long d'une droite orientée dans la direction de liaison des deux magnétorésistances.

8. Dispositif selon l'une quelconque des revendications 1 à 7, caractérisé en ce qu'il comprend un capteur de déplacement (19) pour la détermination de la position de la tête de sondage (1).

9. Dispositif selon l'une quelconque des revendications 5 à 8, caractérisé en ce que les paires de magnétorésistances (32) sont disposées sur un chariot (1) déplaçable sur des roues (17, 18) et que les axes (15, 16) des roues sont orientés parallèlement à la droite.

10. Dispositif selon la revendication 9, caractérisé en ce qu'il comporte deux axes de roues (15, 16) parallèles et couplés en rotation, dont les extrémités portent chacune une roue (17, 18).

11. Dispositif selon l'une des revendications 9 ou 10, caractérisé en ce que le capteur de déplacement (19) est un capteur de déplacement à diaphragme à fente avec un diaphragme à fente (20) tournant entraîné par la rotation d'au moins l'un des axes de roues (15, 16).

12. Dispositif selon l'une quelconque des revendications 1 à 11, caractérisé en ce que l'aimant est un amant permanent.

13. Dispositif selon l'une quelconque des revendications 1 à 12, caractérisé en ce que l'aimant est un électroaimant.
